# EUROPÄISCHE PATENTSCHRIFT

(11) **EP 1 145 439 B1**
(45) Veröffentlichungstag und Bekanntmachung des Hinweises auf die Patenterteilung: **04.09.2002**
(21) Anmeldenummer: 00982964.9
(22) Anmeldetag: 29.09.2000
(51) Int. Cl.: H03L 7/085, H04L 7/033

(54) **PHASENDETEKTOR**
PHASE DETECTOR
DETECTEUR DE PHASE

(30) Priorität: 30.09.1999 DE 19948690
(43) Veröffentlichungstag der Anmeldung: 17.10.2001
(73) Patentinhaber: Infineon Technologies AG, 81669 München (DE)
(72) Erfinder: SCHRÖDINGER, Karl, 14089 Berlin (DE)
(74) Vertreter: Müller, Wolfram Hubertus, Dipl.-Phys.
(86) Internationale Anmeldenummer: DE0003522
(87) Internationale Veröffentlichungsnummer: WO01024370

(56) Entgegenhaltungen:
- DE-C- 4 443 417
- DE-C- 19 717 586
- US-A- 4 422 176
- US-A- 5 027 085
- US-A- 5 770 976

## Beschreibung

Die Erfindung betrifft einen Phasendetektor zur Phasenzentrierung, insbesondere zur Phasenzentrierung in einer Taktregenerierungseinrichtung, der Phasendetektor aufweisend: einen ersten Flip-Flop, wobei ein Eingang des ersten Flip-Flops mit einer Datenleitung, auf welcher Daten mit einer hohen Taktrate übertragbar sind, und ein anderer Eingang des ersten Flip-Flops mit einer Taktleitung verbunden sind, auf welcher erste Taktsignale übertragbar sind, die von einer Oszillatoreinrichtung erzeugbar sind; einen zweiten Flip-Flop, wobei ein Eingang des zweiten Flip-Flops mit einem Ausgang des ersten Flip-Flops und ein anderer Eingang des zweiten Flip-Flops mit einer anderen Taktleitung verbunden sind, auf welcher zweite Taktsignale übertragbar sind, die von der Oszillatoreinrichtung erzeugbar sind; einen dritten Flip-Flop, wobei ein Eingang des dritten Flip-Flops mit einem Ausgang des zweiten Flip-Flops und ein anderer Eingang des dritten Flip-Flops mit der einen Taktleitung verbunden sind; ein erstes XOR-Gatter, wobei ein Eingang des ersten XOR-Gatters mit der Datenleitung, ein anderer Eingang des ersten XOR-Gatters mit dem Ausgang des ersten Flip-Flops und ein Ausgang des ersten XOR-Gatters mit einer ersten Wichtungseinrichtung verbunden sind; ein zweites XOR-Gatter, wobei ein Eingang des zweiten XOR-Gatters mit dem Ausgang des ersten Flip-Flops und dem einen Eingang des zweiten Flip-Flops verbunden ist, wobei ein anderer Eingang des zweiten XOR-Gatters mit dem Ausgang des zweiten Flip-Flops und dem einen Eingang des dritten Flip-Flops verbunden ist, und wobei ein Ausgang des zweiten XOR-Gatters mit einer zweiten Wichtungseinrichtung verbunden ist; und ein drittes XOR-Gatter, wobei ein Eingang des dritten XOR-Gatters mit dem Ausgang des zweiten Flip-Flops und dem einen Eingang des dritten Flip-Flops verbunden ist, wobei ein anderer Eingang des dritten XOR-Gatters mit dem Ausgang des dritten Flip-Flops verbunden ist, und wobei ein Ausgang des dritten XOR-Gatters mit einer dritten Wichtungseinrichtung verbunden ist.

Derartige Vorrichtungen werden benutzt, um die Phasendifferenz zwischen einem Datensignal und einem Taktsignal zu erfassen, und ein Steuersignal zu erzeugen, daß für die ermittelte Phasendifferenz repräsentativ ist. Das Steuersignal wird dann auf die Oszillatoreinrichtung gegeben, welche das Taktsignal erzeugt, um eine Korrektur der Oszillatoreinrichtung auszulösen, so daß die ermittelte Phasendifferenz korrigiert werden kann.

Ein in dieser Weise funktionierender Phasendetektor ist beispielsweise aus dem US-Patent 5,027,085 bekannt. Die eingehenden Daten werden bei dem bekannten Phasendetektor mit einer Taktrate abgetastet, die der Taktrate der eingehenden Daten entspricht. Der bekannte Phasendetektor ist für eine Nutzung in einer Taktregenerierungseinrichtung nicht geeignet, in der die eingehenden Daten mit einer Taktrate abgetastet werden, die der halbierten Taktrate der eingehenden Daten entspricht. Das Abtasten mit der halbierten Taktrate ist bei der Übertragung von Daten mit einer hohen Taktrate an der Geschwindigkeitsgrenze der elektrischen Schaltungen notwendig und üblich.

Aufgabe der vorliegenden Erfindung ist es, einen Phasendetektor zu schaffen, der die Phasenzentrierung ermöglicht, wenn eingehende Daten mit einer Taktrate abgetastet werden, die niedriger als, insbesondere halb so groß wie die Taktrate der eingehenden Daten ist.

Diese Aufgabe wird bei einem Phasendetektor nach dem Oberbegriff des Anspruchs 1 dadurch gelöst, daß ein vierter, ein fünfter und ein sechster Flip-Flop sowie Korrekturmittel zum Erzeugen eines Korrektursignals vorgesehen sind, wobei ein Eingang des vierten Flip-Flops mit der Datenleitung und ein anderer Eingang des vierten Flip-Flops mit der anderen Taktleitung verbunden sind, wobei ein Eingang des fünften Flip-Flops mit einem Ausgangs des vierten Flip-Flops und ein anderer Eingang des fünften Flip-Flops mit der einen Taktleitung verbunden sind, wobei ein Eingang des sechsten Flip-Flops mit einem Ausgang des fünften Flip-Flops und ein anderer Eingang des sechsten Flip-Flops mit der anderen Taktleitung verbunden sind, wobei das Korrektursignal auf eine Integratoreinrichtung gegeben werden kann, in welcher aus dem Korrektursignal und jeweiligen Ausgangssignalen der ersten, der zweiten und der dritten Wichtungseinrichtung ein Steuersignal für die Oszillatoreinrichtung erzeugbar ist, wobei eine Taktrate der ersten und eine Taktrate der zweiten Taktsignale jeweils der durch zwei dividierten, hohe Taktrate entsprechen, und wobei eine Phase der ersten Taktsignale gegenüber einer Phase der zweiten Taktsignale um 180° verschoben ist.

Der wesentliche Vorteil, welcher mit der Erfindung gegenüber dem Stand der Technik erreicht ist, besteht darin, daß eine Möglichkeit zur Nutzung der Phasenzentrierung bei halber Taktrate geschaffen ist. Hierdurch kann die Phasenzentrierung auch bei Daten genutzt werden, die mit hohen Taktraten an der Geschwindigkeitsgrenze elektrischer Schaltungen übertragen werden.

Bei einer zweckmäßigen Weiterbildung der Erfindung umfassen die Korrekturmittel ein weiteres XOR-Gatter, wobei ein Eingang des weiteren XOR-Gatters mit dem Ausgang des ersten Flip-Flops und ein anderer Eingang des weiteren XOR-Gatters mit dem Ausgang des vierten Flip-Flops verbunden sind; ein erstes und ein zweites UND-Gatter, wobei ein Eingang des ersten UND-Gatters und ein Eingang des zweiten UND-Gatters jeweils mit einem Ausgang des weiteren XOR-Gatters verbunden sind, wobei ein anderer Eingang des ersten UND-Gatters und ein anderer Eingang des zweiten UND-Gatters jeweils mit der einen Taktleitung verbunden sind, und wobei ein weiterer Eingang des ersten UND-Gatters mit dem Ausgang des zweiten Flip-Flops verbunden ist; und eine vierte, eine fünfte und eine sechste Wichtungseinrichtung, wobei ein Eingang der vierten Wichtungseinrichtung mit der einen Taktleitung verbunden ist, wobei ein Eingang der fünften Wichtungseinrichtung mit einem Ausgang des ersten UND-Gatters verbunden ist, und wobei ein Eingang der sechsten Wichtungseinrichtung mit einem Ausgang des zweiten UND-Gatters verbunden ist; wobei aus jeweiligen Ausgangssignalen der vierten, der fünften und der sechsten Wichtungseinrichtung das Korrektursignal erzeugbar ist. Hierdurch ist eine Kombination von Logikbausteinen geschaffen, die eine Integration des Phasendetektors in integrierten Schaltungen mit üblicher Technologie ermöglicht.

Bei einer Fortbildung der Erfindung kann vorgesehen sein, daß die eine und die andere Taktleitung mit einer Frequenzdetektoreinrichtung zur Frequenzzentrierung verbunden sind, wobei die Frequenzdetektoreinrichtung mit der Integratoreinrichtung verbunden ist, so daß von der Frequenzdetektoreinrichtung ein Frequenzdetektorsignal an die Integratoreinrichtung übermittelt werden kann, und wobei die Integratoreinrichtung geeignete Schaltmittel umfaßt, um aus dem Frequenzdetektorsignal, dem Korrektursignal und den jeweiligen Ausgangssignalen der ersten, der zweiten und der dritten Wichtungseinrichtung das Steuersignal zu erzeugen. Hierdurch ist es möglich, neben der Phasenzentrierung auch eine Frequenzzentrierung auszuführen. Dieses ist insbesondere bei den hohen Toleranzen üblicher Halbleitertechnologien vorteilhaft.

Die Erfindung wird im folgenden anhand von Ausführungsbeispielen unter Bezugnahme auf eine Zeichnung näher erläutert. Hierbei zeigen:
- Figur 1: eine schematische Darstellung einer Taktregenerierungseinrichtung;
- Figur 2: ein Schaltbild eines Phasendetektors, der in der Taktregenerierungsvorrichtung nach Figur 1 genutzt werden kann;
- Figur 3: eine schematische Darstellung von Datensignalen ohne Korrektur;
- Figur 4: eine schematische Darstellung von Datensignalen mit Korrektur; und
- Figur 5: eine Taktregenerierungseinrichtung mit einem Frequenzdetektor.

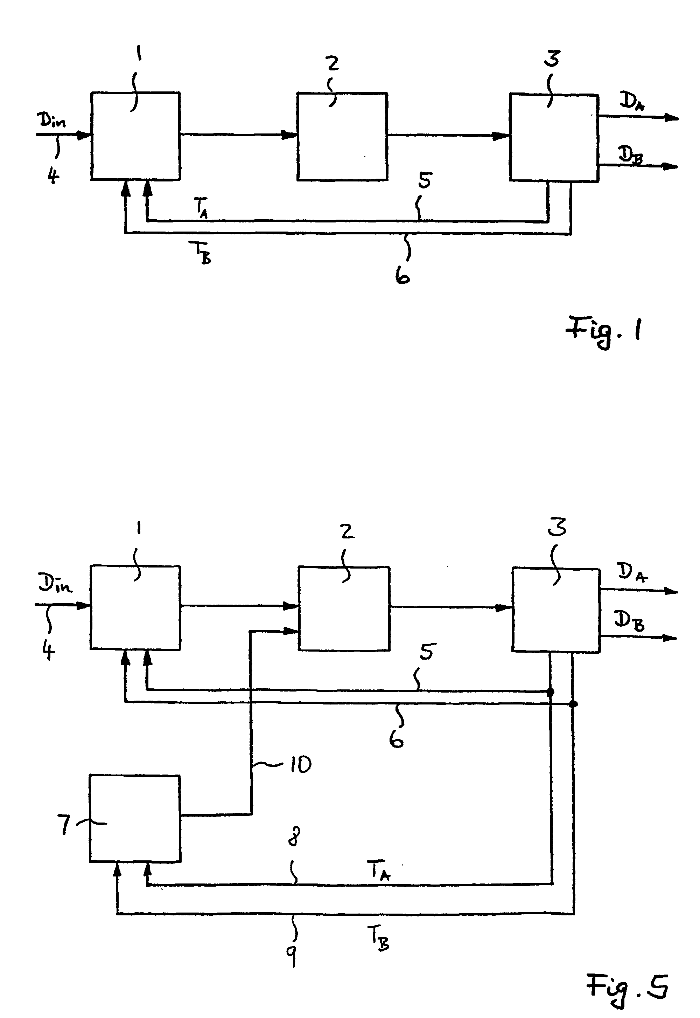

Gemäß Figur 1 umfaßt eine Taktregenerierungseinrichtung einen Phasendetektor 1 eine Integratoreinrichtung 2 und eine Oszillatoreinrichtung 3. Der Phasendetektor 1 empfängt über eine Datenleitung 4 Daten Dᵢₙ. Die Daten Dᵢₙ werden mit einer hohen Taktrate übertragen. Zum Abtasten der Daten Dᵢₙ empfängt der Phasendetektor 1 über eine Taktleitung 5 erste Taktsignale T_{A} und über eine andere Taktleitung 6 zweite Tatsignale T_{B}. Die Taktrate der ersten Taktsignale T_{A} und der zweiten Taktsignale T_{B} entspricht jeweils der durch zwei dividierten hohen Taktrate, mit welcher die Daten Dᵢₙ übertragen werden, wobei eine Phase der ersten Taktsignale T_{A} gegenüber einer Phase der zweiten Taktsignale T_{B} um 180° verschoben ist.

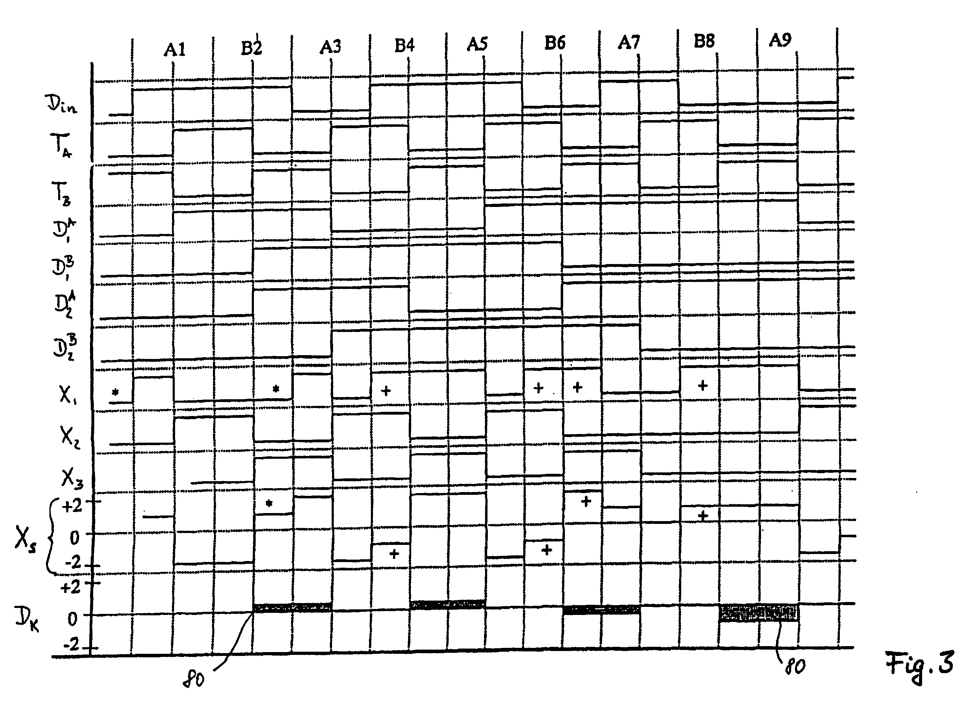

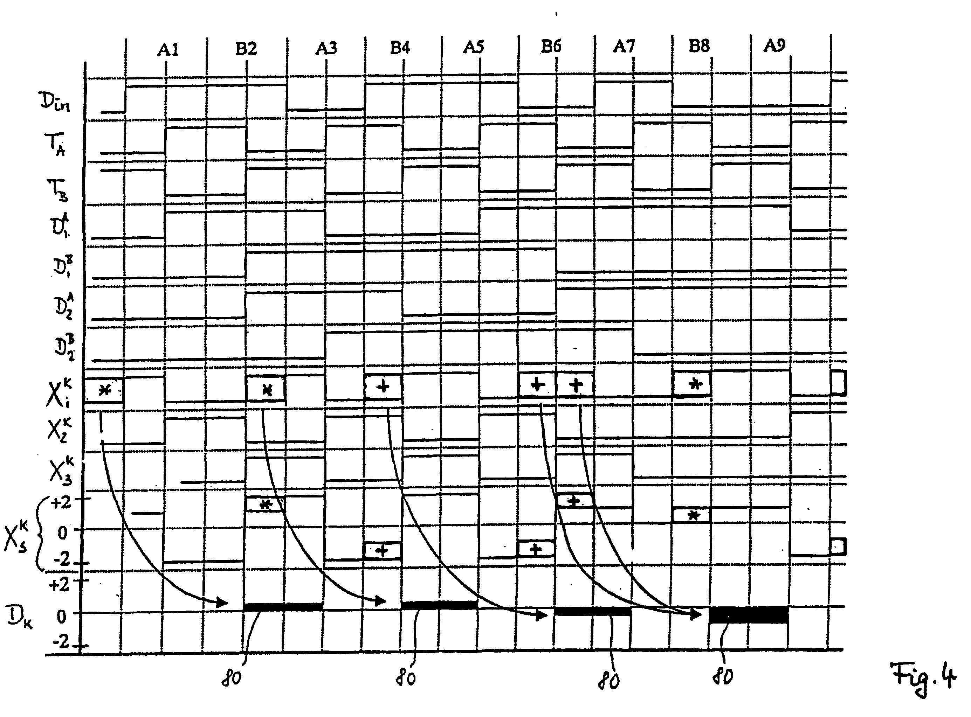

Die Signalverläufe von T_{A}, T_{B} und Dᵢₙ sind jeweils im oberen Bereich der Figuren 3 und 4 dargestellt. Mit Hilfe der ersten und der zweiten Taktsignale T_{A}, T_{B} ist es möglich, die Daten Dᵢₙ in dem Phasendetektor 1 mit einer Taktrate abzutasten, die halb so groß wie die hohe Taktrate der Daten Dᵢₙ ist. Die mit Hilfe der ersten Taktsignale T_{A} und der zweiten Taktsignale T_{B} abgetasteten Daten werden nach erfolgter Taktregenerierung mit Hilfe des Phasendetektors 1, der Integratoreinrichtung 2 und der Oszillatoreinrichtung 3 als ausgehende Daten D_{A} bzw. D_{B} von der Oszillatoreinrichtung ausgegeben (vgl. Figur 1).

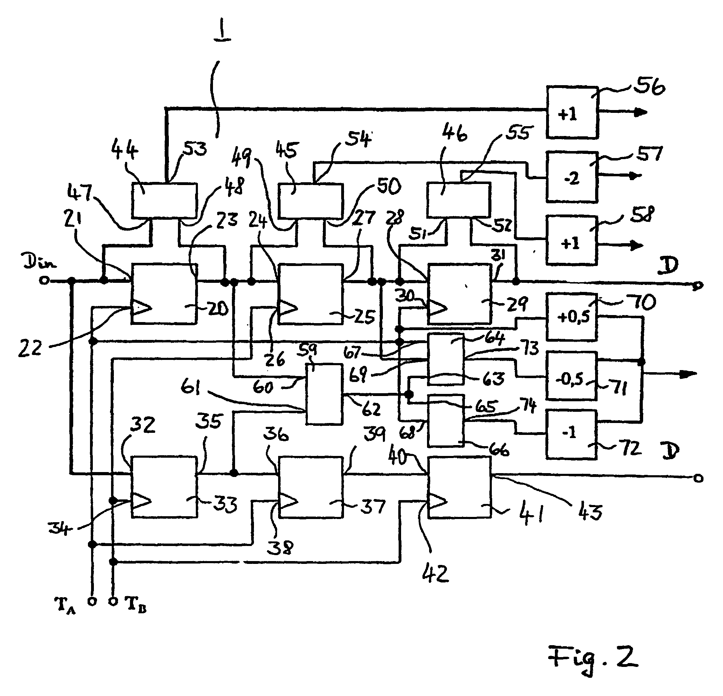

In Figur 2 ist der in Figur 1 schematisch dargestellte Phasendetektor 1 im Detail gezeigt. Ein erster Flip-Flop 20 empfängt über einen Eingang 21 die Daten Dᵢₙ. An einem anderen Eingang 22 des ersten Flip-Flops 20 liegen die ersten Taktsignale T_{A} an. Ein Ausgang 23 des ersten Flip-Flops 20 ist mit einem Eingang 24 eines zweiten Flip-Flops 25 verbunden. An einem anderen Eingang 26 empfängt der zweite Flip-Flop 25 die zweiten Taktsignale T_{B}. Ein Ausgang 27 des zweiten Flip-Flops 25 ist mit einem Eingang 28 eines dritten Flip-Flops 29 verbunden. An einem anderen Eingang 30 empfängt der dritte Flip-Flops 29 die ersten Taktsignale T_{A}. An einem Ausgang 31 des dritten Flip-Flops 29 liegen die Ausgangsdaten D_{A} an.

Um die Daten Dᵢₙ in dem in Figur 2 dargestellten Phasendetektor 1 mit der halbierten hohen Taktrate abzutasten, ist es notwendig, die Daten Dᵢₙ auf einen Eingang 32 eines vierten Flip-Flops 33 zu geben. Der vierte Flip-Flop 33 empfängt über einen anderen Eingang 34 die zweiten Taktsignale T_{B}. Ein Ausgang 35 des vierten Flip-Flops 33 ist mit einem Eingang 36 eines fünften Flip-Flops 37 verbunden. Über einen anderen Eingang 38 empfängt der vierte Flip-Flop 37 die ersten Taktsignale T_{A}. Ein Ausgang 39 des fünften Flip-Flops 37 ist mit einem Eingang 40 eines sechsten Flip-Flops 41 verbunden. Der sechste Flip-Flop 41 empfängt über einen anderen Eingang 42 die zweiten Taktsignale T_{B}. An einem Ausgang 43 des sechsten Flip-Flops 41 liegen die Ausgangsdaten D_{B} vor.

Zur Ausführung einer Phasenzientrierung weist der in Figur 2 dargestellt Phasendetektor 1 ein erstes, ein zweites und ein drittes XOR-Gatter 44, 45, 46 auf. Ein Eingang 47 des ersten XOR-Gatters 44 ist mit dem einen Eingang 21 des ersten Flip-Flops 20 verbunden. Ein anderer Eingang 48 des ersten XOR-Gatters 44 ist mit dem Ausgang 23 des ersten Flip-Flops 20 verbunden. Ein Eingang 49 des zweiten XOR-Gatters 45 ist mit dem Ausgang 23 des ersten Flip-Flops 20 und dem Eingang 24 des zweiten Flip-Flops 25 verbunden. Ein anderer Eingang 50 des zweiten XOR-Gatters 45 ist mit dem Ausgang 27 des zweiten Flip-Flops und dem Eingang 28 des dritten Flip-Flops 29 verbunden. Ein Eingang 51 des dritten XOR-Gatters 46 ist mit dem Ausgang 27 des zweiten Flip-Flops 25 und dem Eingang 28 des dritten Flip-Flops 29 verbunden. Ein anderer Ausgang 52 des dritten XOR-Gatters 46 ist mit dem Ausgang 31 des dritten Flip-Flops 29 verbunden.

Ausgänge 53, 54, 55 des ersten, des zweiten und des dritten XOR-Gatters 44, 45, 46 sind jeweils mit einer Wichtungseinrichtung 56, 57, 58 verbunden. In den Wichtungseinrichtungen 56, 57, 58 werden die jeweils an den Ausgängen der XOR-Gatter 53, 54, 55 anliegenden Signale mit Faktoren +1, -2 bzw. +1 multipliziert (vgl. Figur 2).

Die an den jeweiligen Ausgänge der Flip-Flops 20, 25, 29, 33, 37, 41, der XOR-Gatter 44, 45, 46 sowie der Wichtungseinrichtungen 56, 57, 58 anliegenden Signale sind zum Teil in Figur 3 dargestellt. Hierbei bezeichnen Ai und Bj (i=1,3,5,..; j=2,4,6,...) jeweils Bits der Daten Dᵢₙ, die mittels der ersten bzw. der zweiten Taktsignale T_{A}, T_{B} abgetastet wurden. D^{A}₁ bezeichnet das am Ausgang 23 des ersten Flip-Flops 20 anliegende Signal. D^{A}₂ bezeichnet das am Ausgang 27 des zweiten Flip-Flops 25 anliegende Signal. D^{B}₁ bezeichnet das am Ausgang 35 des vierten Flip-Flops 33 anliegende Signal. D^{B}₂ bezeichnet das am Ausgang 39 des fünften Flip-Flops 37 anliegende Signal.

Xᵢ (i=1,2,3) bezeichnet das jeweilige Ausgangssignal des ersten, des zweiten und des dritten XOR-Gatters 44, 45, 46. Unterhalb der Ausgangssignale Xᵢ ist in Figur 3 ein Summensignal Xₛ dargestellt, welches der Summe der mit Hilfe der Wichtungseinrichtungen 56, 57, 58 jeweils gewichteten Ausgangssignale Xᵢ der XOR-Gatter 44, 45, 46 entspricht.

Wegen der Abtastung der Daten Dᵢₙ mit der halbierten hohen Taktrate treten in den Signalen Xᵢ und Xₛ fehlende Impulsanteile (*) und überschüssige (+) Impulsanteile auf. Um diese fehlenden bzw. überschüssigen Impulsanteile so zu korrigieren, daß mit Hilfe des in Figur 2 dargestellten Phasendetektors 1 eine Phasenzentrierung ermöglicht ist, weist der Phasendetektor 1 Korrekturmittel auf. Die Korrekturmittel umfassen gemäß Figur 2 ein weiteres XOR-Gatter 59. Ein Eingang 60 des weiteren XOR-Gatters 59 ist mit dem Ausgang 23 des ersten Flip-Flops und dem Eingang 24 des zweiten Flip-Flops verbunden. Ein anderer Eingang 61 des weiteren XOR-Gatters 59 ist mit dem Ausgang 35 des vierten Flip-Flops 33 und dem Eingang 36 des fünften Flip-Flops 37 verbunden. Ein Ausgang 62 des weiteren XOR-Gatters 59 ist mit einem Eingang 63 eines ersten UND-Gatters 64 und einem Eingang 65 eines zweiten UND-Gatters 66 verbunden. Das erste UND-Gatter 64 empfängt über eine anderen Eingang 67 die ersten Taktsignale T_{A}. Das zweite UND-Gatter 66 empfängt über einen anderen Eingang 68 gleichfalls die ersten Taktsignale T_{A}. Ein weiterer Eingang 69 des ersten UND-Gatters 64 ist mit dem Ausgang 27 des zweiten Flip-Flops 25 und dem Eingang 28 des dritten Flip-Flops 29 verbunden.

Die Korrekturmittel umfassen weiterhin eine vierte, eine fünfte und eine sechste Wichtungseinrichtung 70, 71, 72. Die vierte Wichtungseinrichtung 70 ist mit dem Eingang 30 des dritten Flip-Flops 29 verbunden. Die fünfte und die sechste Wichtungsreinrichtung 71, 72 sind mit jeweiligen Ausgängen 73, 74 des ersten bzw. des zweiten UND-Gatters 64, 66 verbunden. Die Summierung der Ausgangssignale der vierten, der fünften und der sechsten Wichtungseinrichtung 70, 71, 72 ergibt ein Korrektursignal D_{K}, was im unteren Bereich der Darstellung in Figur 3 gezeigt ist. Die ausgefüllten Flächen 80 stellen das benötigte Korrektursignal D_{K} dar.

Das Korrektursignal D_{K} wird in der Integratoreinrichtung 2 mit dem Summensignal X_{S} kombiniert (vgl. Figur 2), um ein Steuersignal für die Oszillatoreinrichtung 3 zu erzeugen, so daß eine Phasenzentrierung erreicht wird.

In Figur 4 sind neben den bereits in Figur 3 dargestellten Signalen (Dᵢₙ, T_{A}, T_{B}, D^{A}₁, D^{A}₂, D^{B}₁, D^{B}₂) korrigierte, gewichtete Ausgangssignale X^{K}₁, X^{K}₂, X^{K}₃ der ersten, der zweiten und der dritten Wichtungseinrichtung 56, 57, 58 dargestellt. Des weiteren ist ein korrigiertes Summensignal X^{K}ₛ dargestellt.

Zweckmäßig kann vorgesehen sein, daß die Taktregenerierungseinrichtung gemäß Figur 1 durch einen Frequenzdetektor 7 ergänzt ist. Dieses ist in Figur 5 dargestellt. Der Frequenzdetektor 7 ist über Leitungen 8, 9 mit der Oszillatoreinrichtung 3 verbunden. Mit Hilfe des Frequenzdetektors 7 wird ein Frequenzdetektorsignal erzeugt, welches über eine weitere Leitung 10 auf die Integratoreinrichtung 2 gegeben wird. Die Integratoreinrichtung 2 weist geeignete Schaltmittel (nicht dargestellt) auf, um die von dem Phasendetektor 1 und dem Frequenzdetektor 7 empfangenen Signale zu kombinieren, um sowohl eine Phasenzentrierung als auch eine Frequenzzentrierung ausführen zu können.

## Patentansprüche

1. Phasendetektor (1) zur Phasenzentrierung, insbesondere zur Phasenzentrierung in einer Taktregenerierungseinrichtung, der Phasendetektor (1) aufweisend:
- einen ersten Flip-Flop (20), wobei ein Eingang (21) des ersten Flip-Flops (20) mit einer Datenleitung, auf welcher Daten (Din) mit einer hohen Taktrate übertragbar sind, und ein anderer Eingang (22) des ersten Flip-Flops (20) mit einer Taktleitung verbunden sind, auf welcher erste Taktsignale (T_{A}) übertragbar sind, die von einer Oszillatoreinrichtung (3) erzeugbar sind;
- einen zweiten Flip-Flop (25), wobei ein Eingang (24) des zweiten Flip-Flops (25) mit einem Ausgang (23) des ersten Flip-Flops (20) und ein anderer Eingang (26) des zweiten Flip-Flops (25) mit einer anderen Taktleitung verbunden sind, auf welcher zweite Taktsignale (T_{B}) übertragbar sind, die von der Oszillatoreinrichtung (3) erzeugbar sind;
- einen dritten Flip-Flop (29), wobei ein Eingang (28) des dritten Flip-Flops (29) mit einem Ausgang (27) des zweiten Flip-Flops (25) und ein anderer Eingang (30) des dritten Flip-Flops (29) mit der einen Taktleitung verbunden sind;
- ein erstes XOR-Gatter (44), wobei ein Eingang (47) des ersten XOR-Gatters (44) mit der Datenleitung, ein anderer Eingang (48) des ersten XOR-Gatters (44) mit dem Ausgang (23) des ersten Flip-Flops (20) und ein Ausgang (53) des ersten XOR-Gatters (44) mit einer ersten Wichtungseinrichtung (56) verbunden sind;
- ein zweites XOR-Gatter (45), wobei ein Eingang (49) des zweiten XOR-Gatters (45) mit dem Ausgang (23)des ersten Flip-Flops (20) und dem einen Eingang (24) des zweiten Flip-Flops (25) verbunden ist, wobei ein anderer Eingang (50) des zweiten XOR-Gatters (45) mit dem Ausgang (27) des zweiten Flip-Flops (25) und dem einen Eingang (28) des dritten Flip-Flops (29) verbunden ist, und wobei ein Ausgang (54) des zweiten XOR-Gatters (45) mit einer zweiten Wichtungseinrichtung (57) verbunden ist; und
- ein drittes XOR-Gatter, wobei ein Eingang (51) des dritten XOR-Gatters (46) mit dem Ausgang (27) des zweiten Flip-Flops (25) und dem einen Eingang (28) des dritten Flip-Flops (29) verbunden ist, wobei ein anderer Eingang (52) des dritten XOR-Gatters (46) mit dem Ausgang (31) des dritten Flip-Flops (29) verbunden ist, und wobei ein Ausgang (55) des dritten XOR-Gatters (46) mit einer dritten Wichtungseinrichtung (58) verbunden ist;
**gekennzeichnet durch**
- einen vierten Flip-Flop (33), wobei ein Eingang (32) des vierten Flip-Flops (33) mit der Datenleitung und ein anderer Eingang (34)des vierten Flip-Flops (33) mit der anderen Taktleitung verbunden sind;
- einen fünften Flip-Flop (37), wobei ein Eingang (36) des fünften Flip-Flops (37) mit einem Ausgang (35) des vierten Flip-Flops (33) und ein anderer Eingang (38) des fünften Flip-Flops (37) mit der einen Taktleitung verbunden sind;
- einen sechsten Flip-Flop (41), wobei ein Eingang (40) des sechsten Flip-Flops (41) mit einem Ausgang (39) des fünften Flip-Flops (37) und ein anderer Eingang (42) des sechsten Flip-Flops (41) mit der anderen Taktleitung verbunden sind;
- Korrekturmittel (59,64,66,70,71,72) zum Erzeugen eines Korrektursignals, das auf eine Integratoreinrichtung (2) gegeben werden kann, in welcher aus dem Korrektursignal und jeweiligen Ausgangssignalen der ersten, der zweiten und der dritten Wichtungseinrichtung (56,57,58) ein Steuersignal für die Oszillatoreinrichtung (3) erzeugbar ist;
wobei eine Taktrate der ersten und eine Taktrate der zweiten Taktsignale (T_{A},T_{B}) jeweils der **durch** zwei dividierten, hohen Taktrate entsprechen, und wobei eine Phase der ersten Taktsignale (T_{A}) gegenüber einer Phase der zweiten Taktsignale (T_{B}) um 180° verschoben ist.

2. Vorrichtung nach Anspruch 1, die Korrekturmittel umfassend:
- ein weiteres XOR-Gatter (59), wobei ein Eingang (60) des weiteren XOR-Gatters (59) mit dem Ausgang (23) des ersten Flip-Flops (20) und ein anderer Eingang (61) des weiteren XOR-Gatters (59) mit dem Ausgang (35) des vierten Flip-Flops (33)verbunden sind;
- ein erstes und ein zweites UND-Gatter (64,66), wobei ein Eingang (63) des ersten UND-Gatters (64) und ein Eingang (65) des zweiten UND-Gatters (66) jeweils mit einem Ausgang (62) des weiteren XOR-Gatters (59) verbunden sind, wobei ein anderer Eingang (67) des ersten UND-Gatters (64) und ein anderer Eingang (65) des zweiten UND-Gatters (66) jeweils mit der einen Taktleitung verbunden sind, und wobei ein weiterer Eingang (69) des ersten UND-Gatters (64) mit dem Ausgang (27) des zweiten Flip-Flops (25) verbunden ist; und
- eine vierte, eine fünfte und eine sechste Wichtungseinrichtung (70,71,72), wobei ein Eingang der vierten Wichtungseinrichtung (70) mit der einen Taktleitung verbunden ist, wobei ein Eingang der fünften Wichtungseinrichtung (71) mit einem Ausgang (73) des ersten UND-Gatters (64) verbunden ist, und wobei ein Eingang der sechsten Wichtungseinrichtung (72) mit einem Ausgang (74) des zweiten UND-Gatters (66) verbunden ist;
wobei aus jeweiligen Ausgangssignalen der vierten, der fünften und der sechsten Wichtungseinrichtung (70,71,72) das Korrektursignal erzeugbar ist.

3. Vorrichtung nach Anspruch 1 oder 2, **dadurch gekennzeichnet, daß** die eine und die andere Taktleitung mit einer Frequenzdetektoreinrichtung (7) zur Frequenzzentrierung verbunden sind, wobei die Frequenzdetektoreinrichtung (7) mit der Integratoreinrichtung (2) verbunden ist, so daß von der Frequenzdetektoreinrichtung (1) ein Frequenzdetektorsignal an die Integratoreinrichtung (2) übermittelt werden kann, und wobei die Integratoreinrichtung (2) geeignete Schaltmittel umfaßt, um aus dem Frequenzdetektorsignal, dem Korrektursignal und den jeweiligen Ausgangssignalen der ersten, der zweiten und der dritten Wichtungseinrichtung (56,57,58) das Steuersignal zu erzeugen.

## Claims

1. Phase detector (1) for phase centring, in particular for phase centring in a clock regeneration device, the phase detector (1) having:
- a first flipflop (20), where one input (21) of the first flipflop (20) is connected to a data line on which data (Din) can be transmitted at a high clock rate, and another input (22) of the first flipflop (20) is connected to a clock line on which first clock signals (T_{A}) can be transmitted which can be produced by an oscillator device (3);
- a second flipflop (25), where one input (24) of the second flipflop (25) is connected to an output (23) of the first flipflop (20), and another input (26) of the second flipflop (25) is connected to another clock line, on which second clock signals (T_{B}) can be transmitted which can be produced by the oscillator device (3);
- a third flipflop (29), where one input (28) of the third flipflop (29) is connected to an output (27) of the second flipflop (25), and another input (30) of the third flipflop (29) is connected to one clock line;
- a first XOR gate (44), where one input (47) of the first XOR gate (44) is connected to the data line, another input (48) of the first XOR gate (44) is connected to the output (23) of the first flipflop (20), and an output (53) of the first XOR gate (44) is connected to a first weighting device (56);
- a second XOR gate (45), where one input (49) of the second XOR gate (45) is connected to the output (23) of the first flipflop (20) and to one input (24) of the second flipflop (25),
where another input (50) of the second XOR gate (45) is connected to the output (27) of the second flipflop (25) and to one input (28) of the third flipflop (29), and where an output (54) of the second XOR gate (45) is connected to a second weighting device (57); and
- a third XOR gate, where one input (51) of the third XOR gate (46) is connected to the output (27) of the second flipflop (25) and to one input (28) of the third flipflop (29), where another input (52) of the third XOR gate (46) is connected to the output (31) of the third flipflop (29), and where an output (55) of the third XOR gate (46) is connected to a third weighting device (58);
**characterized by**
- a fourth flipflop (33), where one input (32) of the fourth flipflop (33) is connected to the data line, and another input (34) of the fourth flipflop (33) is connected to the other clock line;
- a fifth flipflop (37), where one input (36) of the fifth flipflop (37) is connected to an output (35) of the fourth flipflop (33), and another input (38) of the fifth flipflop (37) is connected to one clock line;
- a sixth flipflop (41) where one input (40) of the sixth flipflop (41) is connected to an output (39) of the fifth flipflop (37), and another input (42) of the sixth flipflop (41) is connected to the other clock line;
- correction means (59, 64, 66, 70, 71, 72) for producing a correction signal which can be passed to an integrator device (2) in which a control signal for the oscillator device (3) can be produced from the correction signal and respective output signals from the first., second and third weighting devices (56, 57, 58);
where a clock rate of the first and a clock rate of the second clock signals (T_{A}, T_{B}) respectively correspond to half the high clock rate, and where a phase of the first clock signals (T_{A}) is shifted by 180° with respect to a phase of the second clock signals (T_{B}).

2. Apparatus according to Claim 1, the correction means comprising:
- a further XOR gate (59), where one input (60) of the further XOR gate (59) is connected to the output (23) of the first flipflop (20), and another input (61) of the further XOR gate (59) is connected to the output (35) of the fourth flipflop (33);
- a first and a second AND gate (64, 66), where one input (63) of the first AND gate (64) and one input (65) of the second AND gate (66) are respectively connected to an output (62) of the further XOR gate (59), where another input (67) of the first AND gate (64) and another input (65) of the second AND gate (66) are respectively connected to one clock line, and where a further input (69) of the first AND gate (64) is connected to the output (27) of the second flipflop (25); and
- a fourth, a fifth and a sixth weighting device (70, 71, 72), where one input of the fourth weighting device (70) is connected to one clock line, where one input of the fifth weighting device (71) is connected to an output (73) of the first AND gate (64), and where one input of the sixth weighting device (72) is connected to an output (74) of the second AND gate (66);
where the correction signal can be produced from respective output signals from the fourth, fifth and sixth weighting devices (70, 71, 72).

3. Apparatus according to Claim 1 or 2, **characterized in that** one and the other clock line are connected to a frequency detector device (7) for frequency centring, the frequency detector device (7) being connected to the integrator device (2), so that the frequency detector device (1) can transmit a frequency detector signal to the integrator device (2), and the integrator device (2) comprising suitable switching means in order to produce the control signal from the frequency detector signal, the correction signal and the respective output signals from the first, second and third weighting devices (56, 57, 58).

## Revendications

1. Détecteur de phase (1) pour le centrage de phase, notamment pour le centrage de phase dans un dispositif de régénération d'horloge, lequel détecteur de phase (1) comporte :
- une première bascule bistable (20), une entrée (21) de la première bascule bistable (20) étant reliée à une ligne de données sur laquelle peuvent être transmises des données (Dᵢₙ) avec un haut débit et une autre entrée (22) de la première bascule bistable (20) étant reliée à une ligne d'horloge sur laquelle peuvent être transmis des premiers signaux d'horloge (T_{A}) qui peuvent être produits par un dispositif oscillateur (3) ;
- une deuxième bascule bistable (25), une entrée (24) de la deuxième bascule bistable (25) étant reliée à une sortie (23) de la première bascule bistable (20) et une autre entrée (26) de la deuxième bascule bistable (25) étant reliée à une autre ligne d'horloge sur laquelle sont transmis des deuxièmes signaux d'horloge (T_{B}) qui peuvent être produits par le dispositif oscillateur (3) ;
- une troisième bascule bistable (29), une entrée (28) de la troisième bascule bistable (29) étant reliée à une sortie (27) de la deuxième bascule bistable (25) et une autre entrée (30) de la troisième bascule bistable (29) étant reliée à la première ligne d'horloge ;
- une première porte XOR (44), une entrée (47) de la première porte XOR (44) étant reliée à la ligne de données, une autre entrée (48) de la première porte XOR (44) à la sortie (23) de la première bascule bistable (20) et une sortie (53) de la première porte XOR (44) à un premier dispositif de pondération (56) ;
- une deuxième porte XOR (45), une entrée (49) de la deuxième porte XOR (45) étant reliée à la sortie (23) de la première bascule bistable (20) et à la première entrée (24) de la deuxième bascule bistable (25), une autre entrée (50) de la deuxième porte XOR (45) étant reliée à la sortie (27) de la deuxième bascule bistable (25) et à la première entrée (28) de la troisième bascule bistable (29) et une sortie (54) de la deuxième porte XOR (45) étant reliée à un deuxième dispositif de pondération (57) ; et
- une troisième porte XOR, une entrée (51) de la troisième porte XOR (46) étant reliée à la sortie (27) de la deuxième bascule bistable (25) et à la première entrée (28) de la troisième bascule bistable (29), une autre entrée (52) de la troisième porte XOR (46) étant reliée à la sortie (31) de la troisième bascule bistable (29) et une sortie (55) de la troisième porte XOR (46) étant reliée à un troisième dispositif de pondération (58) ;
**caractérisé par**
- une quatrième bascule bistable (33), une entrée (32) de la quatrième bascule bistable (33) étant reliée à la ligne de données et une autre entrée (34) de la quatrième bascule bistable (33) à l'autre ligne d'horloge ;
- une cinquième bascule bistable (37), une entrée (36) de la cinquième bascule bistable (37) étant reliée à une sortie (35) de la quatrième bascule bistable (33) et une autre entrée (38) de la cinquième bascule bistable (37) à la première ligne d'horloge ;
- une sixième bascule bistable (41), une entrée (40) de la sixième bascule bistable (41) étant reliée à une sortie (39) de la cinquième bascule bistable (37) et une autre entrée (42) de la sixième bascule bistable (41) à l'autre ligne d'horloge ;
- des moyens de correction (59, 64, 66, 70, 71, 72) pour la production d'un signal de correction pouvant être donné à un dispositif intégrateur (2) dans lequel un signal de commande destiné au dispositif oscillateur (3) peut être produit à partir du signal de correction et des signaux de sortie respectifs du premier, du deuxième et du troisième dispositif de pondération (56, 57, 58);
un débit des premiers signaux d'horloge (T_{A}) et un débit des deuxièmes signaux d'horloge (T_{B}) correspondant à chaque fois au haut débit divisé par deux et une phase des premiers signaux d'horloge (T_{A}) étant décalée de 180° par rapport à une phase des deuxièmes signaux d'horloge (T_{B}).

2. Dispositif selon la revendication 1, les moyens de correction comprenant :
- une autre porte XOR (59), une entrée (60) de l'autre porte XOR (59) étant reliée à la sortie (23) de la première bascule bistable (20) et une autre entrée (61) de l'autre porte XOR (59) à la sortie (35) de la quatrième bascule bistable (33) ;
- une première et une deuxième porte ET (64, 66), une entrée (63) de la première porte ET (64) et une entrée (65) de la deuxième porte ET (66) étant reliées à chaque fois à une sortie (62) de l'autre porte XOR (59), une autre entrée (67) de la première porte ET (64) et une autre entrée (65) de la deuxième porte ET (66) étant reliées à chaque fois à la première ligne d'horloge et une autre entrée (69) de la première porte ET (64) étant reliée à la sortie (27) de la deuxième bascule bistable (25) ; et
- un quatrième, un cinquième et un sixième dispositif de pondération (70, 71, 72), une entrée du quatrième dispositif de pondération (70) étant reliée à la première ligne d'horloge, une entrée du cinquième dispositif de pondération (71) à une sortie (73) de la première porte ET (64) et une entrée du sixième dispositif de pondération (72) à une sortie (74) de la deuxième porte ET (66) ;
le signal de correction pouvant être produit à partir des signaux de sortie respectifs du quatrième, du cinquième et du sixième dispositif de pondération (70, 71, 72).

3. Dispositif selon la revendication 1 ou 2, **caractérisé par le fait que** la première ligne d'horloge et l'autre ligne d'horloge sont reliées à un détecteur de fréquence (7) pour le centrage de fréquence, le détecteur de fréquence (7) étant relié au dispositif intégrateur (2) de telle sorte qu'un signal de détecteur de fréquence peut être transmis du détecteur de fréquence (7) au dispositif intégrateur (2) et le dispositif intégrateur (2) comprenant des moyens de commutation appropriés pour produire le signal de commande à partir du signal de détecteur de fréquence, du signal de correction et des signaux de sortie respectifs du premier, du deuxième et du troisième dispositif de pondération (56, 57, 58).
